# EUROPÄISCHE PATENTSCHRIFT

(11) **EP 1 348 970 B1**
(45) Veröffentlichungstag und Bekanntmachung des Hinweises auf die Patenterteilung: **20.06.2007**
(21) Anmeldenummer: 02405235.9
(22) Anmeldetag: 26.03.2002
(51) Int. Cl.: G01R 31/08

(54) **Plausibilitätsprüfung von Stromwandlern in Unterstationen**
Check for plausibility of current transformers in substations
Test de validité des transformateurs de courant dans des sous-stations

(43) Veröffentlichungstag der Anmeldung: 01.10.2003
(73) Patentinhaber: ABB Schweiz AG, 5400 Baden (CH)
(72) Erfinder: Wimmer, Wolfgang, 5323 Rietheim (CH); Schutter, Jan, 5417 Untersiggenthal (CH)
(74) Vertreter: ABB Patent Attorneys

(56) Entgegenhaltungen:
- EP-A- 1 074 849
- DE-A- 4 142 471

## Beschreibung

### TECHNISCHES GEBIET

Die Erfindung bezieht sich auf das Gebiet der Anlagenleittechnik, insbesondere der Anlagenleittechnik für Hoch-, Mittel- oder Niederspannungsschaltanlagen. Sie geht aus von einem Verfahren, einem Computerprogramm und einer Vorrichtung zur Plausibilitätsüberprüfung von Stromwandlern in einer elektrischen Schaltanlage sowie von einer Schaltanlage mit einer solchen Vorrichtung gemäss Oberbegriff der unabhängigen Patentansprüche.

### STAND DER TECHNIK

Ein Energieverteilnetz umfasst Unterstationen oder elektrische Schaltanlagen, insbesondere Hoch- oder Mittelspannungsschaltanlagen, die durch ein verteiltes Anlagenleitsystem gesteuert werden. Die Unterstationen umfassen Primär- oder Feldgeräte, z. B. Schalter, Antriebe, Generatoren, Transformatoren, Spannungs- und Stromwandler. Das Anlagenleitsystem weist beispielsweise Feldleitgeräte und eine Bedienstation auf, die durch verschiedene Kommunikationsbusse und Buskoppler miteinander verbunden sind. Die Feldleitgeräte steuern, regeln, überwachen und schützen die Feldgeräte der Anlage.

Stromwandler in elektrischen Unterstationen messen die Anlagenströme an vorgegebenen Messstellen der Schaltanlage mit einer gewissen Messungenauigkeit. Die Messstellen befinden sich typischerweise an allen ein- und ausgehenden Abgängen und gegebenenfalls, z. B. für den Sammelschienenschutz, auch innerhalb der Anlage. Die Strommesswerte werden gefiltert, in Primärstromwerte der Anlage skaliert, gegebenenfalls digitalisiert und als Strommesssignale vom Anlagenleitsystem erfasst. Für Kommunikationszwecke kann eine zusätzliche Änderungsraten-Filterung vorgesehen sein, die z. B. eine zeitliche Mittelung durch Integration oder einen Algorithmus zur Entscheidung über Aktualisieren oder Beibehalten und Senden oder Nichtsenden des Strommesswerts umfasst. Die Strommesssignale werden für Schutzfunktionen, zur Überwachung der Unterstation, zur Berechnung von Leistungsdaten für betriebliche Zwecke oder für Leistungsverrechnung und zur Darstellung auf einer Anzeige verwendet. Sowohl die vom Stromwandler erfassten Messwerte als auch die Parameter der Filterung und Skalierung, d. h. die sogenannte Parametrisierung der Messwerte, können fehlerbehaftet sein. Primärfehler im Stromwandler selber entstehen z. B. durch defekte Teile oder Materialermüdung. Fehler in der Parametrisierung oder bei der Leistungsberechnung können in der Elektronik durch äussere Einflüsse, Alterung, Drift, Fehler des Bedienungspersonals o. ä. verursacht sein. Fehler bei der Übertragung von Messwerten oder Messsignalen können in der Geräte- und Funktionskette vom Stromwandler bis zur Bildschirmanzeige oder Netzleitstelle auftreten.

Es ist bekannt, z.B. aus der EP 1074849 oder der DE 4142471, für Schutzzwecke die Stromwandler durch lokale Plausibilitätstests an einem isolierten Punkt der Anlage zu überwachen. Beim Phasen-Symmetrietest (sogenannte "phase balance supervision") werden alle drei Phasenströme und der Nullstrom an einem Punkt in der Leitung gemessen und Abweichungen von einer angenommenen, maximalen Asymmetrie zwischen den Phasen detektiert. Beim Vergleichstest von Strom- und Spannungswerten können grobe Inkonsistenzen zwischen Spannungs- und Stromwerten an der Messstelle aufgedeckt werden. Diese lokalen, auf eine einzelne Messstelle bezogenen Plausibilitätstests sind sehr grob und erlauben nur eine ja/nein-Entscheidung, ob ein Stromwandler funktioniert oder nicht. Eine falsche Skalierung oder ein Genauigkeitsverlust können hingegen nicht festgestellt werden, insbesondere da die Tests im Schutzgerät in der Regel mit Relativwerten zur Nominalspannung durchgeführt werden.

Beim Transformator-Differentialschutz werden die Ströme der Ober- und Unterseite gemessen, mit einem durch das Transformator-Übersetzungsverhältnis gegebenen Skalierungsfaktor versehen und miteinander verglichen. Auf diese Weise können für den Differentialschutz Skalierungsfehler erkannt und korrigiert werden.

Solche Tests werden in Schutzgeräten für Schutz-Stromwandler durchgeführt. Eine Anwendung solcher Algorithmen in Steuergeräten für Mess-Stromwandler ist im allgemeinen nicht möglich, weil in der Regel Transducer für die Digitalisierung der Strommesswerte eingesetzt werden und diese statt der benötigten Momentanwerte zeitgemittelte RMS- oder Effektiv-Werte des Stroms, der Spannung oder der Leistung, Frequenz oder des Phasenwinkels liefern.

### DARSTELLUNG DER ERFINDUNG

Aufgabe der vorliegenden Erfindung ist es, ein Verfahren, ein Computerprogramm, eine Vorrichtung und eine Schaltanlage mit einer solchen Vorrichtung zur verbesserten und vereinfachten Überwachung von Stromwandlern in elektrischen Schaltanlagen anzugeben. Diese Aufgabe wird erfindungsgemäss durch die Merkmale der unabhängigen Ansprüche gelöst.

In einem ersten Aspekt besteht die Erfindung in einem Verfahren zur Plausibilitätsprüfung von Stromwandlern in einer elektrischen Schaltanlage, insbesondere einer Hochoder Mittelspannungsschaltanlage, wobei die Schaltanlage durch ein Anlagenleitsystem gesteuert wird und Messsignale von an mindestens zwei unterschiedlichen Messstellen angeordneten Stromwandlern vom Anlagenleitsystem verarbeitet werden, wobei folgende Schritte zur Plausibilitätsprüfung der Stromwandler ausgeführt werden: (i) Erfassen einer momentanen Topologie der Schaltanlage aufgrund der vorhandenen elektrischen Verbindungen von Primärgeräten und aufgrund momentaner Stellungen von Schaltern durch das Anlagenleitsystem; (ii) aufgrund der momentanen Topologie Identifizieren mindestens einer Zone der Schaltanlage, welche Zone einen leitfähig verbundenen Bereich darstellt, der durch mindestens einen Stromwandler und gegebenenfalls durch offene Schalter begrenzt ist; (iii) Erfassen der Messsignale der Stromwandler in der Zone mit einem stromrichtungsabhängigen Vorzeichen und Addieren der Messsignale zu einer Stromsumme der Zone; und (iv) Prüfen der Stromsumme auf einen Wert Null im Rahmen einer erlaubten Stromwandler-Messgenauigkeit und Markieren der Stromwandler der Zone als problematisch, falls die Stromsumme ungleich Null ist.

Jede Zone stellt also einen Stromknoten dar, dessen Stromsumme idealerweise Null beträgt. Offenen Schaltern kann ein Strommesswert Null zugewiesen werden, da sie Stromwandlern mit Sollstrom Null entsprechen. Die Prüfung der Stromsumme auf Abweichungen vom Idealwert Null stellt ein einfaches, effizientes Verfahren dar, um durch einen Relativvergleich der Stromwandler einer Zone deren Skalierung im Rahmen zulässiger Messsignalabweichungen zu überprüfen. Das Verfahren erfordert wenig Rechenaufwand und keinen zusätzlichen Messaufwand bei den Stromwandlern. Insbesondere muss kein korrekter oder absoluter Stromwert bekannt sein oder geschätzt werden. Die Identifikation von Stromwandlern als problematisch stellt eine erste Warn- oder Alarmstufe dar und signalisiert, dass eine weitere Überwachung der Stromwandler dieser Zone erforderlich ist. Das Verfahren ist unabhängig von der Konfiguration oder dem Netzwerk-Schema der Primärgeräte der Schaltanlage und insbesondere unabhängig von der Komplexität ihrer Vernetzung und kann daher ohne wesentliche Anpassungen für beliebige Schemata implementiert werden. Das Verfahren ist auch unabhängig vom momentanen Betriebszustand der Schaltanlage und kann insbesondere auch bei schwankenden Stromwerten durchgeführt werden. Die Topologieverfolgung geschieht dynamisch, d. h. die Topologie oder die Einteilung in Zonen wird laufend oder bei Bedarf aktualisiert. Insbesondere kann sie sich durch Schalthandlungen ändern. Vorteilhaft ist auch, dass auf bereits im Anlagenleitsystem verfügbare Messsignale der Stromwandler zugegriffen werden kann. Das Verfahren ist auch kompatibel mit herkömmlichen lokalen Plausibilitätstests für Stromwandler. Über diese hinausgehend erlaubt es jedoch, geringe Abweichungen oder Fehler in der Skalierung von Stromwandlern zu detektieren. Ebenfalls können primärseitige gröbere Fehler oder Defekte an Stromwandlern erkannt werden.

Ein bevorzugtes Ausführungsbeispiel umfasst folgende Merkmale: in jeder Zone wird eine gleiche Anzahl Tests auf Vorhandensein einer Stromsumme ungleich Null durchgeführt; bei jedem Test auf Vorhandensein einer Stromsumme ungleich Null wird ein Warnungszähler für die als problematisch identifizierten Stromwandler dieser Zone inkrementiert; und schliesslich werden Stromwandler mit einem höheren Warnungszählerstand als andere Stromwandler, insbesondere mit einem höchsten Warnungszählerstand, als defekt identifiziert. Gehört nämlich ein defekter Stromwandler zu zwei oder mehr Zonen, wird sein Warnzähler bei jeder Stromsummenbildung seiner Zonen hochgezählt, wohingegen die anderen Warnzähler nur um eine Einheit erhöht werden. Der höhere oder höchste Warnzählerstand ist daher ein zuverlässiges Mass zum Erkennen des defekten Stromwandlers.

Das Ausführungsbeispiel gemäss Anspruch 3 hat den Vorteil, dass das Warnsignal eines innerhalb der Schaltanlage angeordneten, nicht defekten Stromwandlers häufig, abhängig von der Reihenfolge der Summenbildung in den Zonen, unmittelbar auf Null zurückgesetzt und der Stromwandler als heil erkannt werden kann.

Das Ausführungsbeispiel gemäss Anspruch 4 hat den Vorteil, dass Zonen mit genau einem Stromwandler sehr einfach und zuverlässig überwacht werden können.

Das Ausführungsbeispiel gemäss Anspruch 5 hat den Vorteil, dass die Stromwandler der gesamten Schaltanlage durch das erfindungsgemässe Verfahren überprüft werden können.

Das Ausführungsbeispiel gemäss Anspruch 6 hat den Vorteil einer besonders einfachen Zonenerkennung und einer schnellen Zonenzusammenlegung im Falle defekter Stromwandler.

Das Ausführungsbeispiel gemäss Anspruch 7 hat den Vorteil, dass ein Betrieb der Schaltanlage mit berechneten Strömen möglich ist.

In weiteren Aspekten betrifft die Erfindung ein Computerprogramm zur Plausibilitätsprüfung von Stromwandlern, wobei die Verfahrenschritte gemäss den Ansprüchen 1-10 durch Programmcode implementiert sind, desweiteren eine Vorrichtung zur Ausführung des Verfahrens und eine Schaltanlage umfassend die Vorrichtung.

Weitere Ausführungen, Vorteile und Anwendungen der Erfindung ergeben sich aus abhängigen Ansprüchen sowie aus der nun folgenden Beschreibung und den Figuren.

### KURZE BESCHREIBUNG DER ZEICHNUNGEN

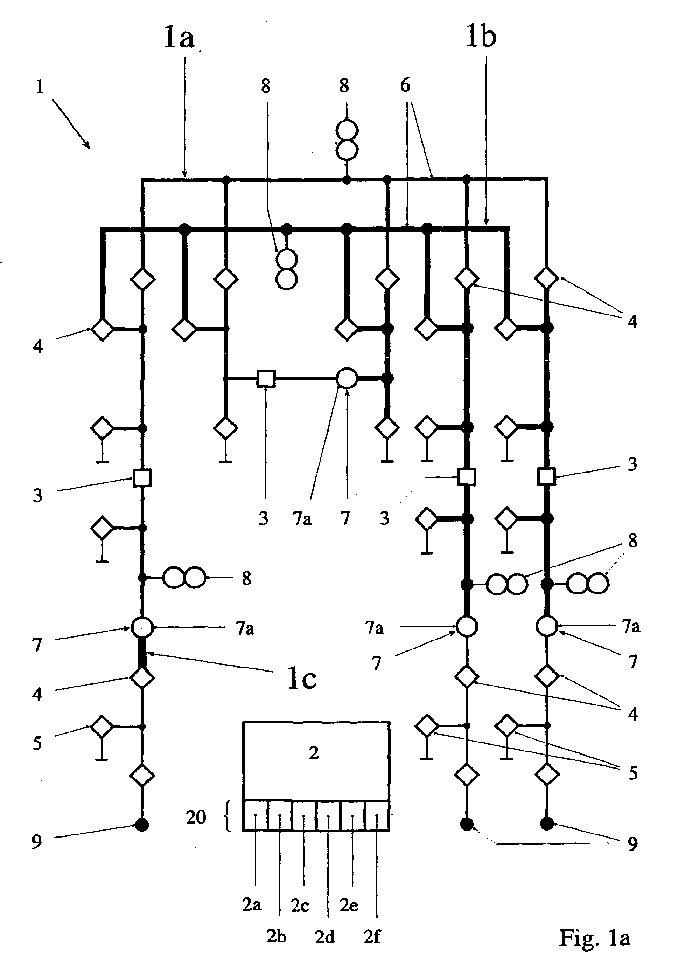

- Fig. 1a: zeigt ein einpoliges Schema in einem ersten, durch Schalterstellungen definierten topologischen Zustand und

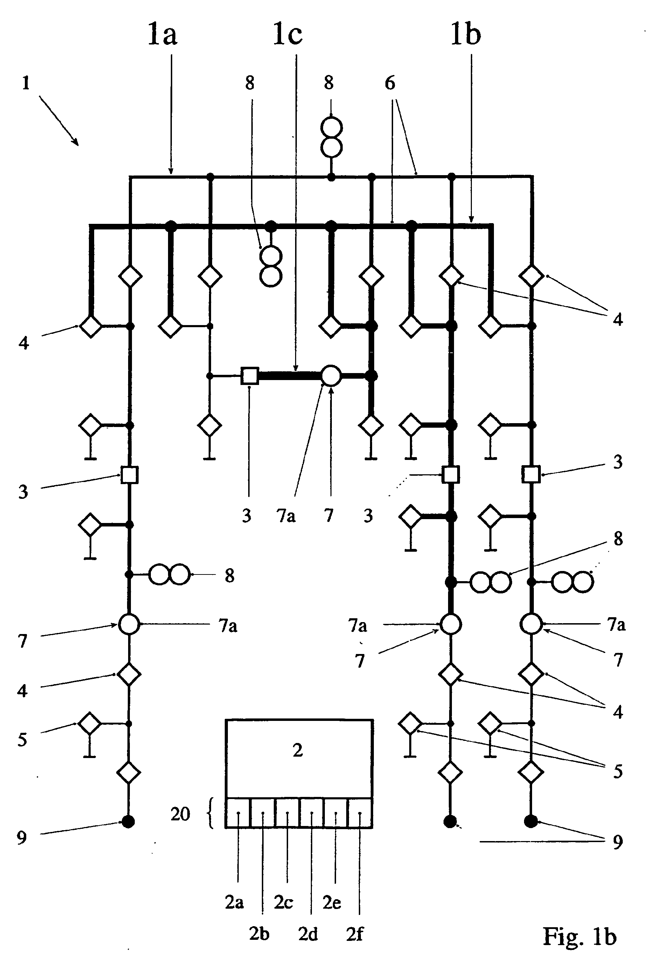

- Fig. 1b: zeigt das einpoliges Schema in einem zweiten topologischen Zustand.

In den Figuren sind gleiche Teile mit gleichen Bezugszeichen versehen.

### WEGE ZUR AUSFÜHRUNG DER ERFINDUNG

Fig. 1a und 1b zeigen ein einpoliges Schema einer elektrischen Hochspannungs-Schaltanlage 1. Ein Anlagenleitsystem 2 der Schaltanlage 1 ist schematisch und ohne die Verbindungen zu den Primärgeräten 3-9 und ohne Bezugnahme auf seine räumliche Anordnung dargestellt. Mit 1a, 1b, 1c sind topologische Teilbereich oder Strombereiche oder Zonen 1a, 1b, 1c bezeichnet, die sich aus der momentan angenommenen Stellung von Leistungsschaltern 3, Trennern 4 und Erdungstrennern 5 ergibt. Die Sammelschienen sind mit 6, die Stromwandler mit 7, die Spannungswandler mit 8 und die Abgänge mit 9 bezeichnet.

In Fig. 1a ist eine erste momentane Topologie mit einer ersten, zweiten und dritten Zone 1a, 1b und 1c dargestellt. Die erste Zone 1a umfasst einen ersten Stromwandler 7 am linken Abgang 9 und einen zweiten Stromwandler 7 im Kupplungsteil zwischen den Sammelschienen 6. Die angrenzende Zone 1b enthält den zweiten Stromwandler 7 und den dritten und vierten Stromwandler 7 an den rechten Abgängen 9. Die andere angrenzende Zone 1c enthält den ersten Stromwandler 7. Alle Stromwandler 7 sind an räumlich getrennten Positionen 7a angeordnet. Erfindungsgemäss werden die Messsignale der Stromwandler 7 separat in jeder zu überwachenden Zone 1a, 1b, 1c mit einem stromrichtungsabhängigen Vorzeichen erfasst und zu einer Stromsumme der jeweiligen Zone 1a, 1b, 1c addiert und es werden bei Vorhandensein einer Stromsumme, die im Rahmen einer erlaubten Stromwandler-Messgenauigkeit ungleich Null ist, alle Stromwandler 7 der jeweiligen zugehörigen Zone 1a, 1b, 1c als problematisch identifiziert. Die Prüfung der Stromsumme auf Null erfolgt im Rahmen eines zulässigen Messfehlers oder aufgrund erlaubter und normalerweise a priori bekannter Messungenauigkeiten der Stromwandler 7. Weichen die Stromsummen um typischerweise mehr als die Messungenauigkeit von Null ab, ist mindestens ein Stromwandler 7 mutmasslich defekt.

Der Übergang von Fig. 1a zu Fig. 1b geschieht dadurch, dass vom Anlagenleitsystem 2 durch eine Topologieverfolgung festgestellt wird, welche Stellungen der Schalter 3-5 momentan aktuell sind. Fig. 1b zeigt einen zweiten topologischen Betriebszustand der Schaltanlage 1, bei dem in der Zone 1a der erste und vierte Stromwandler 7, in der Zone 1b der zweite und dritte Stromwandler 7 und in der neuen Zone 1c der zweite Stromwandler 7 vorhanden sind. Benachbarte Zonen, d. h. Zonen mit einem gemeinsamen Stromwandler 7, sind in Fig. 1a die Zonen 1a, 1b und 1a, 1c, nicht hingegen 1b, 1c, sowie in Fig. 1b die Zonen 1b, 1c. Im Kupplungsteil befindet sich auch ein nicht in Zonen eingeteilter Leitungsbereich, der ausschliesslich durch offene Schalter 3 und Trenner 4 begrenzt ist.

Bei dem Verfahren werden also die an verschiedenen Messstellen 7a erfassten Stromwandler-Messsignale innerhalb jeder Zone 1a, 1b, 1c miteinander auf Konsistenz verglichen, indem bei Abweichungen ihre Stromsumme vom Idealwert Null um mehr als einen vorgebbaren Differenzwert die Stromwandler 7 der zugehörigen Zone 1a, 1b, 1c als problematisch markiert werden. Der Differenzwert ist typischerweise grösser oder gleich der Messungenauigkeit der Wandler 7.

In einer vorteilhaften Ausführungsform werden bei jedem Test einer Zone 1a, 1b, 1c auf Vorhandensein einer Stromsumme ungleich Null ein Warnungszähler 2e für die als problematisch eingestuften Stromwandler 7 hochgezählt. Wenn die zu überwachenden Zonen 1a, 1b, 1c mit gleicher Häufigkeit getestet sind, können Stromwandler 7 mit einem höheren oder mit dem höchsten Warnungszählerstand als defekt markiert werden.

Ein höherer oder höchster Warnungszählerstand ist ein zuverlässiges Mass für defekte Stromwandler 7: Ist in einer Zone 1c mit genau einem Stromwandler 7 dieser defekt, wird sein Warnungszähler 2e hochgezählt und alle anderen Warnungszähler 2e bleiben bei Null. Ist der defekte Stromzähler 7 Mitglied in zwei benachbarten Zonen 1a, 1b; 1a, 1c (Fig. 1a) oder 1b, 1c (Fig. 1b), wird sein Warnungszähler 2e auf den doppelten Wert der heilen Stromwandler 7 dieser Zonen hochgezählt. Ist der defekte Stromzähler 7 Mitglied in einer disjunkten Zone 1a (Fig. 1b), die mit anderen Zonen 1b, 1c (Fig. 1b) nicht überlappt und somit keinen Stromwandler 7 gemeinsam hat, werden die Warnungszähler 2e aller Stromwandler 7 dieser Zone 1a gleichmässig hochgezählt und der defekte Stromwandler 7 kann erst erkannt werden, wenn aufgrund von Schalthandlungen eine andere Topologie oder Zoneneinteilung vorliegt. Zur Identifikation können gegebenenfalls passende Schalthandlungen absichtlich herbeigeführt werden, sofern diese Schalthandlungen mit den sonstigen Anforderungen an den Betrieb der Unterstationen kompatibel sind. Im folgenden werden weitere Ausführungsbeispiele angegeben.

Wenn mindestens eine Zone 1a, 1b mit mehreren Stromwandlern 7 vorhanden ist, werden die Warnungszähler 2e der Stromwandler 7 dieser Zone 1a, 1b auf Null zurückgesetzt, falls in der Zone 1a, 1b eine Stromsumme gleich Null und von mindestens zwei Stromwandlern 7 der Zone 1a, 1b ein Messsignal ungleich Null gemessen werden. In einer Zone 1a, 1b, 1c mit genau einem Stromwandler 7 wird der Stromwandler 7 als defekt identifiziert, wenn sein Messsignal wiederholte Male ungleich Null ist.

Mit Vorteil wird jeder Stromwandler 7 der Schaltanlage 1 in mindestens eine Zone 1a, 1b, 1c eingeteilt und es wird bei einem Gesamttest der Schaltanlage 1 in jeder Zone 1a, 1b, 1c genau ein Test auf Vorhandensein einer Stromsumme ungleich Null durchgeführt. Zum einfachen Identifizieren der Zonen wird von einer Sammelschiene 6 der Schaltanlage 1 ausgegangen und es werden alle damit leitend verbundenen Stromwandler 7 gesucht.

Wenn zwei Zonen 1a, 1b; 1b, 1c der Schaltanlage 1 einander benachbart sind und sie somit über einen gemeinsamen Stromwandler 7 aneinander angrenzen, können die beiden Zonen 1a, 1b; 1b, 1c bei Ausfallen des gemeinsamen Stromwandlers 7 oder bei Erkennen des gemeinsamen Stromwandlers 7 als defekt automatisch zu einer einzigen Zone zusammengefasst werden.

Bei Ausfall genau eines Stromwandlers 7 in einer Zone 1a, 1b, 1c kann ein von diesem Stromwandler 7 zu erfassendes Strommesssignal unter Annahme einer Stromsumme gleich Null aus den übrigen Strommesssignalen der Zone 1a, 1b, 1c berechnet werden. Der berechnete Stromwert kann wie ein gemessenes Strommesssignal zur Betriebsüberwachung oder zur Verrechnung verwendet werden.

Die Plausibilitätsprüfung der Stromwandler 7 kann für jede Phase separat oder für verschiedene Phasen abwechselnd, insbesondere zyklisch abwechselnd, oder für Durchschnittswerte mindestens zweier Phasen, insbesondere aller Phasen, durchgeführt werden. Im Betriebszustand der Schaltanlage 1 können Tests auf Vorhandensein einer Stromsumme ungleich Null und insbesondere Gesamttests der Schaltanlage 1 periodisch und/oder nach Schalthandlungen, d. h. nach jeder Änderung der momentanen Topologie, wiederholt werden. Die Plausibilitätsprüfung der Stromwandler 7 kann unbeachtlich eventueller Schalthandlungen ausgeführt und bei durch Schalthandlungen verursachten Inkonsistenzen der Messsignale wiederholt werden. Alternativ wird die Plausibilitätsprüfung der Stromwandler 7 nur ausgeführt oder ausgewertet, wenn eine vorherige Überprüfung auf momentane Schalthandlungen negativ ausgefallen ist. Die Plausibilitätsprüfung kann auch schon bei Inbetriebnahme von Stromwandlern 7 zur frühzeitigen Erkennung von Inkonsistenzen ihrer Messwert-Parametrisierung durchgeführt werden.

Eine Asynchronizität der Messsignale einer Zone 1a, 1b, 1c kann gemessen oder abgeschätzt und die erlaubte Stromwandler-Ungenauigkeit um so grösser gewählt werden, je grösser die Asynchronizität ist.

Die Ergebnisse der Plausibilitätsprüfung können in Form einer Liste der Stromwandler 7 mit ihrer Zonenzuordnung, einer Statistik, wie häufig jeder Stromwandler 7 als problematisch identifiziert wurde, und/oder als graphische, insbesondere farbliche, Angabe in einem einpoligen Schema der Schaltanlage 1 dargestellt werden. Vorzugsweise sind die Stromwandler 7 Mess-Stromwandler 7, sind die Messsignale effektive Strommesswerte der Stromwandler 7, insbesondere RMS-Werte, und/oder es wird das stromrichtungsabhängige Vorzeichen aus einer Phasenlage zwischen Spannung und Strom einer Phase, zwischen Strömen unterschiedlicher Phasen oder anderweitig bestimmt.

In einem anderen Aspekt betrifft die Erfindung ein Computerprogrammprodukt zur Plausibilitätsüberprüfung von Spannungswandlern 8 in einer elektrischen Schaltanlage 1, umfassend ein computerlesbares Medium und computerlesbare Programmcodemittel, welche bei Ausführung auf einem Datenverarbeitungsmittel eines Anlagenleitsystems 2 der elektrischen Schaltanlage 1 das Datenverarbeitungsmittel zur Ausführung des oben dargestellten Verfahrens bringen. Ferner wird beansprucht ein Computerprogramm zur Plausibilitätsprüfung von Stromwandlern 7 in einer elektrischen Schaltanlage 1, das auf einer Datenverarbeitungseinheit eines Anlagenleitsystems 2 der Schaltanlage 1 ladbar und ausführbar ist, wobei das Computerprogramm bei Ausführung die Schritte des oben dargestellten Verfahrens ausführt.

In einem weiteren Aspekt betrifft die Erfindung eine Vorrichtung 20 zur Ausführung des Verfahrens zur Plausibilitätsüberprüfung von Stromwandlern 7. Die Vorrichtung umfasst Mittel 2a zum Erfassen der momentanen Schaltanlagen-Topologie, Mittel 2b zum Erkennen mindestens einer Schaltanlagen-Zone 1a, 1b, 1c, definiert als leitfähiger, durch mindestens einen Stromwandler 7 und gegebenenfalls offene Schalter 3-5 begrenzter Bereich 1a, 1b, 1c, Mittel 2c zum Erfassen der Messsignale der Stromwandler 7 in der Zone 1a, 1b, 1c mit einem stromrichtungsabhängigen Vorzeichen und zum Addieren der Messsignale zu einer Stromsumme der Zone 1a, 1b, 1c, und Mittel 2d zum Prüfen der Stromsumme auf einen Wert Null im Rahmen einer erlaubten Stromwandler-Messgenauigkeit und zum Markieren der Stromwandler 7 der Zone 1a, 1b, 1c als problematisch, falls die Stromsumme ungleich Null ist. Bevorzugt umfasst die Vorrichtung 20 einen Warnungszähler 2e zur Überwachung der Häufigkeit, mit der ein Stromwandler 7 als problematisch identifiziert wird, und/oder Mittel 2f zur Ausführung des oben dargestellten Verfahrens.

Die Vorrichtung 20 kann ein mit dem Anlagenleitsystem 2 verbindbares Stationsüberwachungsgerät 20 sein oder sie kann in einer Bedienungsschnittstelle des Anlagenleitsystems 2 integriert sein. Ferner können sämtliche genannte Vorrichtungsmittel 2a-2f in Hardware und/oder Software implementiert sein.

Die Erfindung erstreckt sich auch auf eine elektrische Schaltanlage 1, die eine solche Vorrichtung 20 umfasst.

### BEZUGSZEICHENLISTE

- 1: Elektrische Schaltanlage
- 1a, 1b, 1c: Teilbereiche der Topologie, Zonen
- 2: Anlagenleitsystem
- 20: Vorrichtung zur Plausibilitätsüberprüfung
- 2a: Mittel zur Topologieerfassung
- 2b: Mittel zum Erkennen einer Zone
- 2c: Mittel zur Messsignalerfassung
- 2d: Mittel zur Stromsummenprüfung
- 2e: Warnungszähler
- 2f: Ausführungsmittel
- 3: Leistungsschalter
- 4: Trenner
- 5: Trenner-Erder
- 6: Sammelschiene
- 7: Stromwandler
- 7a: Messstelle eines Stromwandlers
- 8: Spannungswandler
- 9: Abgänge

## Patentansprüche

1. Verfahren zur Plausibilitätsprüfung von Stromwandlern (7) in einer elektrischen Schaltanlage (1), insbesondere einer Hoch- oder Mittelspannungsschaltanlage (1), wobei die Schaltanlage (1) durch ein Anlagenleitsystem (2) gesteuert wird und Messsignale von an mindestens zwei unterschiedlichen Messstellen (7a) angeordneten Stromwandlern (7) vom Anlagenleitsystem (2) verarbeitet werden, **dadurch gekennzeichnet, dass** zur Plausibilitätsprüfung der Stromwandler (7)
a) eine momentane Topologie der Schaltanlage (1) aufgrund der vorhandenen elektrischen Verbindungen von Primärgeräten (3-9) und aufgrund momentaner Stellungen von Schaltern (3-5) vom Anlagenleitsystem (2) erfasst wird,
b) aufgrund der momentanen Topologie mindestens eine Zone (1a, 1b, 1c) der Schaltanlage (1) identifiziert wird, welche Zone (1a, 1b, 1c) einen leitfähig verbundenen Bereich (1a, 1b, 1c) darstellt, der durch mindestens einen Stromwandler (7) und gegebenenfalls durch offene Schalter (3-5) begrenzt ist,
c) in der Zone (1a, 1b, 1c) die Messsignale der Stromwandler (7) mit einem stromrichtungsabhängigen Vorzeichen erfasst und zu einer Stromsumme der Zone (1a, 1b, 1c) addiert werden und
d) bei Vorhandensein einer Stromsumme, die im Rahmen einer erlaubten Stromwandler-Messgenauigkeit ungleich Null ist, alle Stromwandler (7) der zugehörigen Zone (1a, 1b, 1c) als problematisch identifiziert werden.

2. Das Verfahren nach Anspruch 1, **dadurch gekennzeichnet, dass**
a) bei jedem Test auf Vorhandensein einer Stromsumme ungleich Null ein Warnungszähler (2e) für die als problematisch identifizierten Stromwandler (7) der zugehörigen Zone (1a, 1b, 1c) inkrementiert wird,
b) in jeder Zone (1a, 1b, 1c) eine gleiche Anzahl Tests auf Vorhandensein einer Stromsumme ungleich Null durchgeführt wird und
c) Stromwandler (7) mit einem höheren Warnungszählerstand als andere Stromwandler (7), insbesondere mit einem höchsten Warnungszählerstand, als defekt identifiziert werden.

3. Das Verfahren nach einem der vorangehenden Ansprüche, **dadurch gekennzeichnet, dass**
a) mindestens eine Zone (1a, 1b) mit mehreren Stromwandlern (7) vorhanden ist und
b) die Warnungszähler (2e) der Stromwandler (7) dieser Zone (1a, 1b) auf Null zurückgesetzt werden, falls in der Zone (1a, 1b) eine Stromsumme gleich Null und von mindestens zwei Stromwandlern (7) der Zone (1a, 1b) ein Messsignal ungleich Null gemessen wird.

4. Das Verfahren nach einem der vorangehenden Ansprüche, **dadurch gekennzeichnet, dass** in einer Zone (1c) mit genau einem Stromwandler (7) der Stromwandler (7) als defekt identifiziert wird, wenn sein Messsignal wiederholte Male ungleich Null ist.

5. Das Verfahren nach einem der vorangehenden Ansprüche, **dadurch gekennzeichnet, dass**
a) jeder Stromwandler (7) der Schaltanlage (1) in mindestens eine Zone (1a, 1b, 1c) eingeteilt wird und
b) bei einem Gesamttest der Schaltanlage (1) in jeder Zone (1a, 1b, 1c) genau ein Test auf Vorhandensein einer Stromsumme ungleich Null durchgeführt wird.

6. Das Verfahren nach einem der vorangehenden Ansprüche, **dadurch gekennzeichnet, dass**
a) zum Identifizieren der Zonen (1a, 1b, 1c) von einer Sammelschiene (6) der Schaltanlage (1) ausgegangen wird und alle damit leitend verbundenen Stromwandler (7) gesucht werden und/oder
b) zwei Zonen (1a, 1b; 1b, 1c) der Schaltanlage (1) identifiziert werden, die einander benachbart sind und die über einen gemeinsamen Stromwandler (7) aneinander angrenzen und bei Ausfallen des gemeinsamen Stromwandlers (7) oder bei Erkennen des gemeinsamen Stromwandlers (7) als defekt die beiden Zonen (1a, 1b; 1b, 1c) automatisch zu einer einzigen Zone zusammengefasst werden.

7. Das Verfahren nach einem der vorangehenden Ansprüche, **dadurch gekennzeichnet, dass** bei Ausfall genau eines Stromwandlers (7) in einer Zone (1a, 1b, 1c) ein von diesem Stromwandler (7) zu erfassendes Strommesssignal unter Annahme einer Stromsumme gleich Null aus den übrigen Strommesssignalen der Zone (1a, 1b, 1c) berechnet wird.

8. Das Verfahren nach einem der vorangehenden Ansprüche, **dadurch gekennzeichnet, dass** die Plausibilitätsprüfung der Stromwandler (7) für jede Phase separat oder für verschiedene Phasen abwechselnd, insbesondere zyklisch abwechselnd, oder für Durchschnittswerte mindestens zweier Phasen, insbesondere aller Phasen, durchgeführt wird.

9. Das Verfahren nach einem der vorangehenden Ansprüche, **dadurch gekennzeichnet, dass**
a) im Betriebszustand Tests auf Vorhandensein einer Stromsumme ungleich Null und insbesondere Gesamttests der Schaltanlage (1) periodisch und/oder nach Schalthandlungen wiederholt werden und/oder
b) die Plausibilitätsprüfung der Stromwandler (7) unbeachtlich eventueller Schalthandlungen ausgeführt und bei durch Schalthandlungen verursachten Inkonsistenzen der Messsignale wiederholt wird oder die Plausibilitätsprüfung der Stromwandler (7) nur ausgeführt oder ausgewertet wird, wenn eine vorherige Überprüfung auf momentane Schalthandlungen negativ ausgefallen ist.

10. Das Verfahren nach einem der vorangehenden Ansprüche, **dadurch gekennzeichnet, dass** im Betriebszustand der Schaltanlage (1) eine Asynchronizität der Messsignale einer Zone (1a, 1b, 1c) gemessen oder abgeschätzt wird und die erlaubte Stromwandler-Ungenauigkeit um so grösser gewählt wird, je grösser die Asynchronizität ist.

11. Das Verfahren nach einem der vorangehenden Ansprüche, **dadurch gekennzeichnet, dass** Ergebnisse der Plausibilitätsprüfung in Form einer Liste der Stromwandler (7) mit ihrer Zonenzuordnung, einer Statistik, wie häufig jeder Stromwandler (7) als problematisch identifiziert wurde, und/oder als graphische, insbesondere farbliche, Angabe in einem einpoligen Schema der Schaltanlage (1) dargestellt werden.

12. Das Verfahren nach einem der vorangehenden Ansprüche, **dadurch gekennzeichnet, dass**
a) die Stromwandler (7) Mess-Stromwandler (7) sind und/oder
b) die Messsignale effektive Strommesswerte der Stromwandler (7) sind und/oder
c) das stromrichtungsabhängige Vorzeichen aus einer Phasenlage zwischen Spannung und Strom einer Phase oder zwischen Strömen unterschiedlicher Phasen bestimmt wird.

13. Computerprogramm zur Plausibilitätsprüfung von Stromwandlern (7) in einer elektrischen Schaltanlage (1), das auf einer Datenverarbeitungseinheit eines Anlagenleitsystems (2) der Schaltanlage (1) ladbar und ausführbar ist, **dadurch gekennzeichnet, dass** das Computerprogramm bei Ausführung alle Schritte des Verfahrens nach einem der Ansprüche 1-10 ausführt.

14. Vorrichtung (20) zur Plausibilitätsprüfung von Stromwandlern (7) in einer elektrischen Schaltanlage (1), insbesondere zur Ausführung des Verfahrens nach einem der Ansprüche 1-12, **gekennzeichnet durch** das Vorhandensein von
a) Mitteln (2a) zum Erfassen einer momentanen Topologie der Schaltanlage (1) aufgrund der vorhandenen elektrischen Verbindungen von Primärgeräten (3-9) und aufgrund momentaner Stellungen von Schaltern (3-5),
b) Mitteln (2b) zum Erkennen mindestens einer Zone (1a, 1b, 1c) der Schaltanlage (1), welche Zone (1a, 1b, 1c) einen leitfähig verbundenen Bereich (1a, 1b, 1c) darstellt, der **durch** mindestens einen Stromwandler (7) und gegebenenfalls **durch** offene Schalter (3-5) begrenzt ist,
c) Mitteln (2c) zum Erfassen der Messsignale der Stromwandler (7) in der Zone (1a, 1b 1c) mit einem stromrichtungsabhängigen Vorzeichen und zum Addieren der Messsignale zu einer Stromsumme der Zone (1a, 1b, 1c) und
d) Mitteln (2d) zum Prüfen der Stromsumme auf einen Wert Null im Rahmen einer erlaubten Stromwandler-Messgenauigkeit und zum Markieren der Stromwandler (7) der Zone (1a, 1b, 1c) als problematisch, falls die Stromsumme ungleich Null ist.

15. Vorrichtung (20) nach Anspruch 14, **dadurch gekennzeichnet, dass**
a) ein Warnungszähler (2e) zur Ausführung des Verfahrens nach Anspruch 2 oder 3 vorhanden ist und/oder
b) Mittel (2f) zur Ausführung des Verfahrens nach einem der Ansprüche 4-12 vorhanden sind.

16. Elektrische Schaltanlage (1), insbesondere Hoch- oder Mittelspannungsschaltanlage (1), **gekennzeichnet durch** eine Vorrichtung (20) nach einem der Ansprüche 14-15.

## Claims

1. A method for the plausibility checking of current transformers (7) in an electrical switchgear (1), in particular a high or medium voltage switchgear (1), the switchgear (1) being controlled by a control system (2) and measuring signals from current transformers (7) arranged at at least two different measuring points (7a) being processed by the control system (2), **characterized in that**, for testing the plausibility of the current transformers (7),
a) an instantaneous topology of the switchgear (1) is recorded by means of the control system (2) based on the existing electrical connections of primary devices (3-9) and based on instantaneous positions of switches (3-5),
b) based on the instantaneous topology, at least one zone (1a, 1b, 1c) of the switchgear (1) is identified, which zone (1a, 1b, 1c) represents a conductively connected area (1a, 1b, 1c) which is bounded by at least one current transformer (7) and possibly by open switches (3-5),
c) in the zone (1a, 1b, 1c), the measurement signals of the current transformers (7) are detected with a current-direction-dependent sign and are added to form a current sum of the zone (1a, 1b, 1c), and,
d) if there is a current sum which is not equal to zero within a permissible current transformer measuring accuracy, all current transformers (7) of the associated zone (1a, 1b, 1c) are identified as being problematic.

2. The method as claimed in claim 1, **characterized in that**
a) in each test for the presence of a current sum not equal to zero, a warning counter (2e) for the current transformers (7) identified as being problematic in the associated zone (1a, 1b, 1c) is incremented,
b) in each zone (1a, 1b, 1c), a same number of tests for the presence of a current sum not equal to zero is performed, and
c) current transformers (7) having a higher warning count than other current transformers (7), in particular having a highest warning count, are identified as being defective.

3. The method as claimed in any of the preceding claims, **characterized in that**
a) there is at least one zone (1a, 1b) having a plurality of current transformers (7), and
b) the warning counters (2e) of the current transformers (7) of this zone (1a, 1b) are reset to zero, if in the zone (1a, 1b) a current sum equal to zero and by at least two current transformers (7) of the zone (1a, 1b) a measuring signal not equal to zero is measured.

4. The method as claimed in any of the preceding claims, **characterized in that** in a zone (1c) having exactly one current transformer (7), the current transformer (7) is identified as being defective if its measuring signal is repeatedly not equal to zero.

5. The method as claimed in any of the preceding claims, **characterized in that**
a) each current transformer (7) of the switchgear (1) is divided into at least one zone (1a, 1b, 1c), and
b) in an overall test of the switchgear (1) exactly one test for the presence of a current sum not equal to zero is performed in each zone (1a, 1b, 1c).

6. The method as claimed in any of the preceding claims, **characterized in that**
a) for identifying the zones (1a, 1b, 1c) one starts from a busbar (6) of the switchgear (1) and all current transformers (7) conductively connected thereto are searched and/or
b) two zones (1a, 1b; 1b, 1c) of the switchgear (1) are identified which are adjacent to one another and which adjoin one another via a common current transformer (7) and if the common current transformer (7) fails or if the common current transformer (7) is detected as being defective, the two zones (1a, 1b; 1b, 1c) are automatically combined to form a single zone.

7. The method as claimed in any of the preceding claims, **characterized in that**, when exactly one current transformer (7) fails in one zone (1a, 1b, 1c), a current measuring signal to be detected by this current transformer (7) is calculated from the remaining current measuring signals of the zone (1a, 1b, 1c), assuming that the current sum is equal to zero.

8. The method as claimed in any of the preceding claims, **characterized in that** the plausibility test of the current transformers (7) is performed separately for each phase or alternately for different phases, in particular in a cyclically alternating fashion, or for average values of at least two phases, in particular of all phases.

9. The method as claimed in any of the preceding claims, **characterized in that**
a) in the operating state, tests for the presence of a current sum not equal to zero and, in particular, overall tests of the switchgear (1) are repeated periodically and/or after switching actions, and/or
b) the plausibility test of the current transformers (7) is carried out regardless of any switching actions and is repeated in the case of inconsistencies of the measuring signals caused by switching actions or the plausibility test of the current transformers (7) is only carried out or evaluated, if a previous check for instantaneous switching actions has had a negative result.

10. The method as claimed in any of the preceding claims, **characterized in that** in the operating state of the switchgear (1), an asynchronism of the measuring signals of a zone (1a, 1b, 1c) is measured or estimated and, the greater the asynchronism, the greater the permitted current transformer inaccuracy to be selected.

11. The method as claimed in any of the preceding claims, **characterized in that** results of the plausibility test are represented in the form of a list of the current transformers (7) with their zone allocation, as statistics of the frequency with which each current transformer (7) has been identified as being problematic and/or as graphical information, in particular as colored information, in a single-pole diagram of the switchgear (1).

12. The method as claimed in any of the preceding claims, **characterized in that**
a) the current transformers (7) are measuring current transformers (7) and/or
b) the measuring signals are effective current measuring values of the current transformers (7) and/or
c) the current-direction-dependent sign is determined from a phase angle between voltage and current of a phase or between currents of different phases.

13. A computer program for the plausibility checking of current transformers (7) in an electrical switchgear (1), which can be loaded and executed on a data processing unit of a control system (2) of the switchgear (1), **characterized in that** the computer program, when executed, executes the steps of the method as claimed in any of the claims 1-10.

14. A device (20) for the plausibility checking of current transformers (7) in an electrical switchgear. (1), in particular for carrying out the method as claimed in any of the claims 1-12, **characterized by** the presence of
a) means (2a) for recording an instantaneous topology of the switchgear (1) based on the existing electrical connections of primary devices (3-9) and based on instantaneous positions of switches (3-5),
b) means (2b) for detecting at least one zone (1a, 1b, 1c) of the switchgear (1), which zone (1a, 1b, 1c) represents a conductively connected area (1a, 1b, 1c) which is bounded by at least one current transformer (7) and possibly by open switches (3-5),
c) means (2c) for detecting the measuring signals of the current transformers (7) in the zone (1a, 1b, 1c) with a current-direction-dependent sign and for adding the measuring signals to form a current sum of the zone (1a, 1b, 1c), and
d) means (2d) for testing the current sum for a value of zero within a permitted current transformer measurement accuracy and for marking the current transformers (7) of the zone (1a, 1b, 1c) as being problematic, if the current sum is not equal to zero.

15. The device (20) as claimed in claim 14, **characterized in that**
a) there is a warning counter (2e) for carrying out the method as claimed in claim 2 or 3, and/or
b) there are means (2f) for carrying out the method as claimed in one of claims 4-12.

16. An electrical switchgear (1), in particular a high or medium voltage switchgear (1), **characterized by** a device (20) as claimed in one of claims 14-15.

## Revendications

1. Procédé de contrôle de plausibilité de transformateurs de courant (7) dans une installation de distribution électrique (1), notamment une installation de distribution à haute ou moyenne tension (1), dans lequel l'installation de distribution (1) est commandée par un système de gestion technique d'installation (2) et des signaux de mesure sont traités par des transformateurs de courant (7) disposés à au moins deux points de mesure différents (7a) du système de gestion technique d'installation (2), **caractérisé en ce que**, pour le contrôle de plausibilité des transformateurs de courant (7),
a) une topologie momentanée de l'installation de distribution (1) est enregistrée à partir des connexions électriques existantes des appareils primaires (3-9) et à partir des positions momentanées des interrupteurs (3-5) du système de gestion technique d'installation (2),
b) à partir de la topologie momentanée, au moins une zone (1a, 1b, 1c) de l'installation de distribution (1) est identifiée, laquelle zone (1a, 1b, 1c) constitue une zone rattachée avec conductivité (1a, 1b, 1c) qui est limitée par au moins un transformateur de courant (7) et le cas échéant par des interrupteurs ouverts (3-5),
c) dans la zone (1a, 1b, 1c), les signaux de mesure des transformateurs de courant (7) sont enregistrés avec un signe dépendant du sens du courant et additionnés en une somme de courant de la zone (1a, 1b, 1c) et
d) en cas de présence d'une somme de courant différente de zéro dans le cadre d'une précision de mesure permise du transformateur de courant, tous les transformateurs de courant (7) de la zone afférente (1a, 1b, 1c) sont identifiés comme étant problématiques.

2. Procédé selon la revendication 1, **caractérisé en ce que**
a) à chaque test de présence d'une somme de courant différente de zéro, un compteur d'avertissement (2e) est incrémenté pour les transformateurs de courant (7) étant identifiés comme problématiques de la zone afférente (1a, 1b, 1c),
b) dans chaque zone (1a, 1b, 1c), un même nombre de tests de présence d'une somme de courant est réalisé et
c) les transformateurs de courant (7) ayant un niveau de compteur d'avertissement supérieur à celui des autres transformateurs de courant (7), notamment ceux ayant un niveau de compteur d'avertissement maximal, sont identifiés comme étant défectueux.

3. Procédé selon une des revendications précédentes, **caractérisé en ce que**
a) au moins une zone (1a, 1b) comprenant plusieurs transformateurs de courant (7) est disponible et
b) les compteurs d'avertissement (2e) des transformateurs de courant (7) de cette zone (1a, 1b) sont remis à zéro si une somme de courant égale à zéro est mesurée dans la zone (1a, 1b) et si un signal de mesure différent de zéro est mesuré par au moins deux transformateurs de courant (7) de la zone (1a, 1b).

4. Procédé selon une des revendications précédentes, **caractérisé en ce que**, dans une zone (1c) comprenant exactement un transformateur de courant (7), le transformateur de courant (7) est identifié comme étant défectueux si son signal de mesure est différent de zéro un nombre répété de fois.

5. Procédé selon une des revendications précédentes, **caractérisé en ce que**
a) chaque transformateur de courant (7) de l'installation de distribution (1) est divisé en au moins une zone (1a, 1b, 1c) et
b) lors d'un test global de l'installation de distribution (1) dans chaque zone (1a, 1b, 1c), exactement un test de présence d'une somme de courant différente de zéro est réalisé.

6. Procédé selon une des revendications précédentes, **caractérisé en ce que**
a) on part pour identifier les zones (1a, 1b, 1c) d'une barre collectrice (6) de l'installation de distribution (1) et on cherche tous les transformateurs de courant (7) qui y sont rattachés avec conductivité et/ou
b) on identifie deux zones (1a, 1b ; 1b, 1c) de l'installation de distribution (1) qui sont voisines et qui sont adjacentes par le biais d'un transformateur de courant commun (7) et, en cas de panne du transformateur de courant commun (7) ou en cas de détection de la défectuosité du transformateur de courant commun (7), les deux zones (1a, 1b ; 1b, 1c) sont regroupées automatiquement en une seule zone.

7. Procédé selon une des revendications précédentes, **caractérisé en ce qu'**en cas de panne d'exactement un transformateur de courant (1) dans une zone (1a, 1b, 1c), un signal de mesure de courant à enregistrer par ce transformateur de courant (7), en supposant une somme de courant égale à zéro, est calculé à partir des autres signaux de mesure de courant de la zone (1a, 1b, 1c).

8. Procédé selon une des revendications précédentes, **caractérisé en ce que** le contrôle de plausibilité des transformateurs de courant (7) est réalisé séparément pour chaque phase ou alternativement pour des phases différentes, notamment alternativement de manière cyclique, ou pour des valeurs moyennes au moins de deux phases, notamment de toutes les phases.

9. Procédé selon une des revendications précédentes, **caractérisé en ce que**
a) en état de fonctionnement, des tests de présence d'une somme de courant différente de zéro et notamment des tests globaux de l'installation de distribution (1) sont réalisés périodiquement et/ou après des actions de commutation et/ou que
b) le contrôle de plausibilité des transformateurs de courant (7) est répété sans tenir compte d'éventuelles actions de commutation et en cas d'inconsistances dues à des actions de commutation des signaux de mesure ou que le contrôle de plausibilité des transformateurs de courant (7) n'est réalisé ou exploité que si un contrôle préalable des actions de commutation a eu un résultat négatif.

10. Procédé selon une des revendications précédentes, **caractérisé en ce qu'**en état de fonctionnement de l'installation de distribution (1), une asynchronicité des signaux de mesure d'une zone (1a, 1b, 1c) est mesurée ou estimée et que l'imprécision permise du transformateur de courant est d'autant plus élevée que l'asynchronicité est forte.

11. Procédé selon une des revendications précédentes, **caractérisé en ce que** les résultats du contrôle de plausibilité sont représentés sous forme d'une liste des transformateurs de courant (7) avec leur attribution de zone, d'une statistique sur la fréquence à laquelle chaque transformateur de courant (7) est identifié comme étant problématique et/ou sous forme d'indication graphique, notamment en couleurs, dans un schéma unipolaire de l'installation de distribution (1).

12. Procédé selon une des revendications précédentes, **caractérisé en ce que**
a) les transformateurs de courant (7) sont des transformateurs de courant de mesure (7) et/ou
b) les signaux de mesure sont des valeurs de mesure de courant effectives des transformateurs de courant (7) et/ou
c) le signe dépendant du sens de courant est défini à partir d'une position de phase entre la tension et le courant d'une phase ou entre des courants de phases différentes.

13. Programme informatique pour le contrôle de plausibilité de transformateurs de courant (7) dans une installation de distribution électrique (1), qui peut être chargé et exécuté sur une unité de traitement de données d'un système de gestion technique d'installation (2) de l'installation de distribution (1), **caractérisé en ce que** le programme informatique, lors de son exécution, réalise toutes les étapes du procédé selon une des revendications 1 à 1.0.

14. Dispositif (20) de contrôle de plausibilité de transformateurs de courant (7) dans une installation de distribution électrique (1), notamment pour la réalisation du procédé selon une des revendications 1 à 12, **caractérisé par** la présence de
a) moyens (2a) d'enregistrement d'une typologie momentanée de l'installation de distribution (1) à partir des connexions électriques existantes des appareils primaires (3-9) et à partir des positions momentanées des interrupteurs (3-5),
b) moyens (2b) de détection d'au moins une zone (1a, 1b, 1c) de l'installation de distribution (1), laquelle zone (1a, 1b, 1c) constitue une zone rattachée avec conductivité (1a, 1b, 1c) qui est limitée par au moins un transformateur de courant (7) et le cas échéant par des interrupteurs ouverts (3-5),
c) moyens (2c) d'enregistrement des signaux de mesure des transformateurs de courant (7) dans la zone (1a, 1b, 1c) avec un signe dépendant du sens du courant et d'additionnement des signaux de mesure en une somme de courant de la zone (1a, 1b, 1c),
d) moyens (2d) de contrôle de la valeur zéro d'une somme de courant dans le cadre d'une précision de mesure permise des transformateurs de courant et de marquage comme étant problématiques des transformateurs de courant (7) de la zone (1a, 1b, 1c) si la somme de courant est différente de zéro.

15. Dispositif (20) selon la revendication 14, **caractérisé en ce que**
a) un compteur d'avertissement (2e) pour réaliser le procédé selon la revendication 2 ou 3 est disponible et/ou
b) des moyens (2f) de réalisation du procédé selon une des revendications 4 à 12 sont disponibles.

16. Installation de distribution électrique (1), notamment installation de distribution à haute ou moyenne tension (1), **caractérisée par** un dispositif (20) selon une des revendications 14 à 15.
